# EUROPEAN PATENT APPLICATION

(11) **EP 4 815 679 A2**
(43) Date of publication of application: **30.09.2026**
(21) Application number: 26198161.7
(22) Date of filing: 18.06.2025
(51) Int. Cl.: H10F 19/80

(54) **METHOD AND SYSTEM FOR THE TREATMENT OF PHOTOVOLTAIC PANELS**

(30) Priority: 18.06.2024 IT 202400013945
(62) Document number(s) of the earlier application(s) in accordance with Art. 76 EPC: 25740152.1 / 4 716 596
(71) Applicant: Eurekhub S.r.l., 15045 Sale (AL) (IT)
(72) Inventor: MANFRON, Riccardo, 15045 SALE (AL) (IT)
(74) Representative: Studio Torta S.p.A.

(57) **Abstract**

There is described a method for the treatment of photovoltaic panels (10; 10") comprising the steps of i) arranging at least one photovoltaic panel (10; 10") comprising a layer (14) made of a vitreous material in a process chamber (2; 2"); ii) hitting the photovoltaic panel (10; 10") with a grit (20; 20‴‴ʺ), so as to achieve the crushing of the layer (14); iii) collecting the vitreous material obtained following step ii).

## Description

### Cross-Reference to Related Applications

This Patent Application claims priority from Italian Patent Application No. 102024000013945 filed on June 18, 2024.

### Field of the Art

The present invention relates to a method for the treatment and recovery of photovoltaic panels. The present invention also relates to a system for the treatment and recovery of photovoltaic panels.

### Context

Photovoltaic panels of known type generally comprise a metal frame to which there are connected:
- two thermoplastic films;
- a layer of photovoltaic cells in a position interposed between the films along the thickness direction of the photovoltaic panels; and
- a layer of glass arranged on the side of one of the two films facing away from the layer of photovoltaic cells.

The photovoltaic panels also comprise:
- a support layer, known as *"backsheet";* and
- one or more junction boxes for the electrical connection of the photovoltaic panel to an electrical network.

Photovoltaic panels comprising two layers of glass, each arranged at respective opposed parts of the layer of photovoltaic cells along the thickness direction of the panels themselves, are also known.

The photovoltaic panels at the end of their useful life can be subjected to dismounting and recycling processes, thanks to which it is possible to obtain reusable materials as secondary raw materials in new production processes. Specifically, the photovoltaic panels to be recycled are a potential source of glass, metals (such as silver, copper or aluminium), silicon and plastics.

A first known type of photovoltaic panel recycling process includes grinding the entire panels by means of grinding blades and the subsequent recovery of some components following grinding (for example, aluminium or copper). This first type of process is associated with high processing speeds (of the order of 500 panels per hour), but has numerous disadvantages.

Firstly, the process of the first type does not allow the recovery of the glass of the photovoltaic panels. In fact, following grinding the entire panel, the glass obtained is polluted by the other ground components. The polluted glass can be minimally recovered in special plants and is finally discharged to landfill.

Secondly, the grinding blades used in the process of the first type are subject to high levels of wear.

A second known type of photovoltaic panel recycling process provides for the removal of the metal frame from the panels and the subsequent lamination of the remaining layers by means of appropriate lamination rollers.

The lamination step results in the crushing of the glass layer of the panels, facilitating the subsequent recovery of other recyclable materials from the photovoltaic panels. However, the recycling process of the second type is associated with low processing speeds (of the order of 15 panels per hour) and high costs.

Moreover, similarly to the recycling processes of the first type, the lamination rollers tend to wear considerably due to the abrasiveness of the glass of the photovoltaic panels with which they come into contact during the lamination step.

In addition, since a certain amount of crushed glass remains on the photovoltaic panel being processed at the end of the lamination step, the problem of wear also and above all concerns the components of the recycling plant arranged downstream of the lamination rollers (for example, single-shaft grinders, disintegration turbines, sieves and pneumatic transport systems).

In light of the above, the need is felt to obtain a technical solution that allows dismounting of the photovoltaic panels and the subsequent recovery of the related recyclable materials in an efficient and economical way.

An aim of the invention is to meet the need set out above, preferably in a simple and reliable manner.

Known devices and methods for the separation and recycling of the glass from the photovoltaic panels are also described in JP2023024841A, JP3793677B2, CN115816313A and DE112022003767T5.

### Summary of the Invention

The aim is achieved by a method for the treatment of photovoltaic panels and by a system for the treatment of photovoltaic panels as claimed in the independent claims.

In particular, the present invention relates to a method for the treatment of photovoltaic panels comprising the steps of:
i) arranging at least one said photovoltaic panel (in a process chamber; said photovoltaic panel comprising at least one layer made of a vitreous material;
ii) hitting said photovoltaic panel with a grit, so as to achieve the crushing of said layer;
iii) collecting the vitreous material obtained following said step ii).

According to an aspect of the invention, during said step i), said photovoltaic panel is inclined with respect to the direction of the versor of the gravity acceleration or is parallel to the direction of the versor of the gravity acceleration.

According to another aspect of the invention, during said step ii) said grit is emitted from at least one nozzle and said layer is at least partially directed towards said at least one nozzle.

According to another aspect of the invention, during said step ii) said grit is emitted by at least one centrifugal thruster and said layer is at least partially turned towards said at least one centrifugal thruster.

According to another aspect of the invention, the method comprises the step iv) of moving said at least one centrifugal thruster with respect to said photovoltaic panel along a direction, which is vertical, in use.

According to another aspect of the invention, the method comprises the step v) of removing a module for the electrical connection of the photovoltaic panel from said photovoltaic panel before said step ii).

According to another aspect of the invention, the method comprises the further steps of:
vi) overturning said photovoltaic panel obtained at the end of said step ii); said photovoltaic panel comprising a further layer made of a vitreous material;
vii) arranging said overturned photovoltaic panel in a further process chamber;
viii) hitting said photovoltaic panel with said grit on the side of said further layer, so as to achieve the crushing of said further layer.

According to another aspect of the invention, the method comprises the step ix) of hitting said photovoltaic panel with said grit, so as to achieve the crushing of a further layer of said photovoltaic panel;
wherein during said step ix) said grit is emitted by at least one further nozzle, said further layer is at least partially turned towards said further nozzle and said further nozzle is arranged opposed to said nozzle with respect to said photovoltaic panel being treated; or
wherein during said step ix) said grit is emitted by at least one further centrifugal thruster, said further layer is at least partially turned towards said further centrifugal thruster and said further centrifugal thruster is opposite said centrifugal thruster with respect to said photovoltaic panel being treated;
said step ix) being simultaneous with or subsequent to said step ii).

According to another aspect of the invention, said grit is magnetic and said method comprises the further step x) of collecting said magnetic grit following said step ii) by means of a magnetic attraction force.

According to another aspect of the invention, said grit is magnetic, paramagnetic, diamagnetic or non-magnetic and said method comprises the steps of:
xi) obtaining a set of said grit and of said vitreous material following said step ii);
xii) detecting the presence and/or position of said grit within said set; and
xiii) selectively removing said grit from said set.

According to another aspect of the invention, the method comprises the step of:
xiv) containing said set in a hopper; and
xv) transporting a quantity of said set unloaded from said hopper towards at least one case;
wherein said step xiii) comprises selectively emitting a jet of compressed air at said set during said step xv).

According to another aspect of the invention, wherein said step xii) comprises the further steps of:
xvi) emitting light at least at part of said set during said step xv);
xvii) detecting images of said set at one or more bands of the electromagnetic spectrum during said step xv);
wherein said step xiii) of selectively removing said grit from said set is carried out on the basis of said images detected during said step xvii).

According to another aspect of the invention, the method comprises the further steps of:
xviii) emitting X-rays at least at part of said set during said step xv);
xix) receiving the X-rays emitted by said X-ray emitter and to emit a signal correlated to the X-rays received;
wherein said step xiii) of selectively removing said grit from said set is carried out on the basis of said signal emitted during said step xix).

In particular, the present invention also relates to a system for the treatment of photovoltaic panels comprising:
- a process chamber adapted to accommodate, in use, a photovoltaic panel;
- at least one nozzle and/or at least one centrifugal thruster arranged inside said process chamber and adapted to eject, in use, a grit against said photovoltaic panel in order to cause at least partial crushing thereof; and
- a device for collecting the crushed portions of said photovoltaic panel.

According to an aspect the invention, the system comprises a structure adapted to support, in use, said photovoltaic panel in an inclined manner with respect to the direction of the versor of the gravity acceleration; or
the system comprises a structure adapted to support, in use, said photovoltaic panel in a manner parallel to the direction of the versor of the gravity acceleration.

According to another aspect the invention, said structure comprises a conveyor belt adapted to move said photovoltaic panel with respect to said process chamber.

According to another aspect the invention, the system comprises an aerial conveyor adapted to move said photovoltaic panel with respect to said process chamber.

According to another aspect the invention, the system comprises:
- a first said process chamber adapted to house a first step of emission of said grit against said photovoltaic panel;
- an overturning device of said photovoltaic panel; and
- a second said process chamber, adapted to house a second step of emission of said grit against said photovoltaic panel overturned, in use, by said overturning device.

According to another aspect the invention, said process chamber comprises a bottom and a top, which are opposed to each other along a direction, which is vertical, in use;
said system further comprising:
   - at least a first said nozzle or one said centrifugal thruster arranged at said top; and
   - at least one second said nozzle or a further said centrifugal thruster arranged at said bottom;
said at least first nozzle and said at least second nozzle being adapted to eject, in use, said grit against respective opposite parts of said photovoltaic panel; or
said at least one centrifugal thruster and said at least one further centrifugal thruster being adapted to eject, in use, said grit against respective parts of said photovoltaic panel that are opposed to each other.

According to another aspect the invention, each said centrifugal thruster comprises:
- a body;
- an impeller, which is supported by said body in a rotatable manner about an axis of rotation; and
- a source of mechanical energy, which is operatively connected to said impeller and is configured to drive said impeller in rotation about said axis of rotation;
said impeller comprising a plurality of blades configured to interact with said grit and increase its kinetic energy.

According to another aspect the invention, the system comprises a movement system configured to move said at least one centrifugal thruster along a direction, which is vertical, in use.

According to another aspect the invention, said movement system comprises:
- a portal fixed with respect to said process chamber; and
- a shelf, which is slidable with respect to said portal along said direction and supporting said at least one centrifugal thruster.

According to another aspect the invention, the system comprises a plurality of centrifugal thrusters fixed with respect to said process chamber and arranged at respective different heights along said direction.

According to another aspect the invention, said grit is magnetic and said system comprises a device adapted to collect said magnetic grit by means of a magnetic attraction force.

According to another aspect the invention, said grit is magnetic, paramagnetic, diamagnetic or non-magnetic and said system comprises an assembly adapted to separate said grit from a set of said grit and of said vitreous material obtained, in use, following said crushing;
said assembly comprising:
   - a sensor system configured to detect the presence and/or position of said grit within said set;
   - an expulsion system configured to selectively remove said grit from said set; and
   - an electronic control unit operatively connected to said sensor system and to said expulsion system;
said electronic control unit being configured to command said expulsion system to selectively remove said grit from said set when said sensor system detects the presence and/or position of said grit within said set.

According to another aspect the invention, said assembly comprises:
- a conveyor;
- a hopper configured to contain said set and to discharge in a controlled manner over time a certain amount of the aforesaid set onto said conveyor; and
- a collection case configured to contain said grit;
wherein said expulsion system comprises a plurality of nozzles configured to selectively emit a jet of compressed air at said set during transport of said set from said hopper to said case.

According to another aspect the invention, said sensor system comprises:
- a light source configured to emit light at least at part of said set; and
- an image acquisition device configured to detect images of said set at one or more bands of the electromagnetic spectrum;
said electronic control unit being configured to command said expulsion system to selectively remove said grit from said set on the basis of said images.

According to another aspect the invention, said sensor system comprises:
- an X-ray emitter configured to emit X-rays at least at part of said set; and
- an X-ray receiver configured to receive the X-rays emitted by said X-ray emitter and to emit a signal correlated to the X-rays, in use, received;
said electronic control unit being configured to command said expulsion system to selectively remove said grit from said set based on said signal.

### Brief Description of the Drawings

For a better understanding of the present invention, eight preferred embodiments are described below, by way of non-limiting example only and with reference to the accompanying drawings, wherein:
- Figure 1 is a perspective view of a system for the treatment of photovoltaic panels according to a first embodiment of the present invention and with parts removed for the sake of clarity;
- Figure 2 is a partial perspective view of the system for the treatment of photovoltaic panels of Figure 1 on an enlarged scale;
- Figure 3 is a schematic and side view of the system for the treatment of photovoltaic panels of Figures 1 and 2;
- Figure 4 is an exploded view of a photovoltaic panel of known type;
- Figure 5 is a perspective view of a system for the treatment of photovoltaic panels according to a second embodiment of the present invention and with parts removed for the sake of clarity;
- Figure 6 is a block diagram of a system for the treatment of photovoltaic panels according to a third embodiment of the present invention and with parts removed for the sake of clarity;
- Figure 7 is an exploded view of a further photovoltaic panel of known type;
- Figure 8 is a schematic and side view of a system for the treatment of photovoltaic panels according to a fourth embodiment of the present invention with parts removed for the sake of clarity;
- Figure 9 is a partial perspective view of a system for the treatment of photovoltaic panels according to a fifth embodiment of the present invention;
- Figure 10 is a schematic and side view of the system for the treatment of photovoltaic panels of Figure 9;
- Figure 11 is a split perspective view of a component of the system for the treatment of photovoltaic panels shown in Figures 9 and 10;
- Figure 12 is a schematic view of a system for the treatment of photovoltaic panels, according to an embodiment of the present invention;
- Figure 13 is a schematic view of a system for the treatment of photovoltaic panels according to a seventh embodiment of the present invention; and
- Figure 14 is a schematic view of a system for the treatment of photovoltaic panels according to an eighth embodiment of the present invention.

### Detailed Description of the Invention

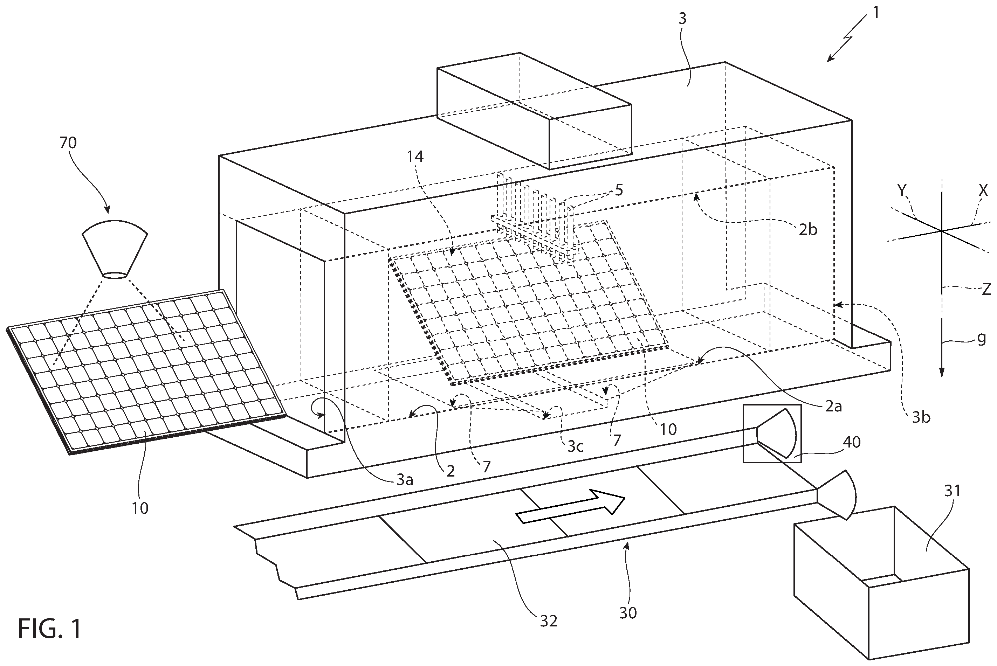

With reference to Figures 1 to 3, 1 denotes a system for the treatment of photovoltaic panels 10, in particular for the purpose of dismounting and recovering related materials.

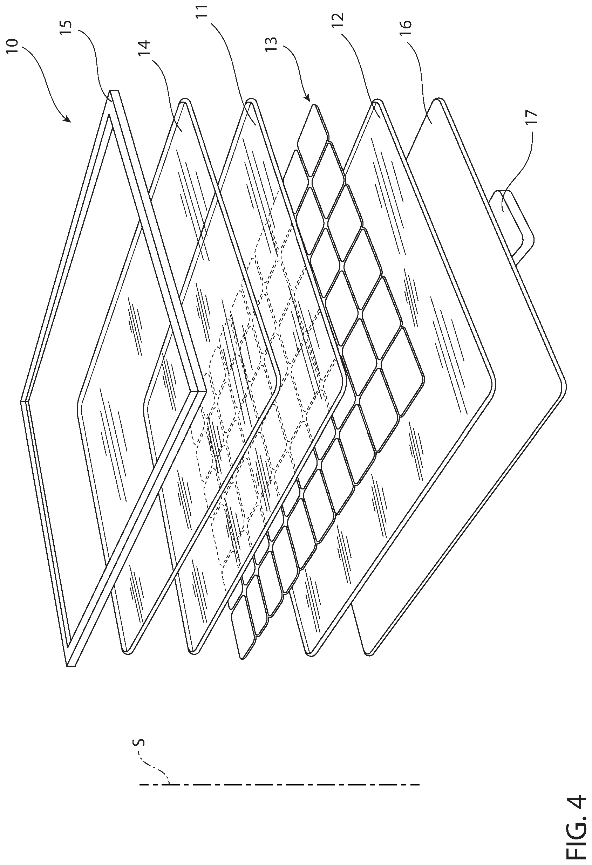

By way of non-limiting example, the photovoltaic panels 10 dismountable by means of the system 1 comprise (Figure 4) :
- a first film 11 in a thermoplastic material;
- a second film 12 in a thermoplastic material;
- a layer 13 comprising CGIS photovoltaic cells interposed between the first film 11 and the second film 12 along a direction S of the thickness of the photovoltaic panels 10;
- a layer 14 made of a vitreous material arranged on the side of the first film 11 facing away from the layer 13 parallel to the direction S; and
- a frame 15 adapted to support the first film 11, the second film 12 and the layers 13 and 14.

Still as shown in Figure 4, the photovoltaic panels 10 comprise:
- a support layer 16 or *"backsheet",* which is arranged on the side of the second film 12 facing away from the layer 13; and
- a module 17 for the electrical connection - for example, to an electrical network - of the photovoltaic panel 10, in particular a junction box.

Preferably but not necessarily, the photovoltaic panels 10 dismountable by means of the system 1 have maximum dimensions equal to 2 x 3 m in the plane orthogonal to the direction S.

Specifically, the system 1 is adapted to remove the layer 14 of vitreous material from the photovoltaic panels 10, in order to make subsequent recycling possible.

The system 1 comprises (Figure 1):
- a process chamber 2 adapted to accommodate the photovoltaic panel 10 to be dismounted;
- a plurality of nozzles 5 adapted to eject a magnetic grit 20 against the photovoltaic panel 10, causing the crushing of part of the photovoltaic panel 10; and
- a device 30 for collecting the crushed portions of the photovoltaic panel 10.

The system 1 can be associated with a reference system comprising:
- a direction Z vertical to the ground on which the system 1 itself rests;
- a direction X horizontal to the ground and orthogonal to the direction Z; and
- a direction Y orthogonal to the directions X and Z.

In detail, the direction Z is directed parallel to the versor g of the gravity acceleration acting at the system 1.

The system 1 comprises a fixed frame 3, which encloses the process chamber 2 therein (Figure 1). In the embodiment shown, the frame 3 has a parallelepiped or substantially parallelepiped shape.

The frame 3 comprises, in turn:
- an opening 3a adapted to selectively allow the entry of the photovoltaic panels 10 to be dismounted in the process chamber 2; and
- an opening 3b adapted to allow the discharge of materials resulting from the treatment of the photovoltaic panels 10 from the process chamber 2.

In the embodiment shown, the openings 3a and 3b are aligned with each other along the direction X.

As shown in Figure 1, the process chamber 2 is also preferably parallelepiped or substantially parallelepiped shaped and comprises a bottom 2a and a top 2b, which are opposed to each other along the direction Z. In detail, the bottom 2a is closer to the ground than the top 2b.

The nozzles 5 are adapted to eject an aeriform flow, which conveys the magnetic grit 20 against the photovoltaic panel 10. Therefore, the operation carried out by the nozzles 5 on the photovoltaic panel 10 to be dismounted can be understood as sandblasting, shot blasting or shot peening.

In detail, the aeriform flow comprises compressed air. In further detail, the aeriform flow is at a pressure ranging from 5 to 12 atm. Preferably, the aeriform flow is at a pressure equal to 8 atm.

The magnetic grit 20 comprises bodies in a metallic material.

In detail, the bodies of the magnetic grit 20 have a spherical or substantially spherical shape and have a diameter ranging from 0 to 10 mm. Preferably, such bodies have a diameter ranging from 120 to 3335 x 10⁻³ mm.

Specifically, diameter can be understood as the average diameter of the bodies or the maximum diameter of the bodies that form the magnetic grit 20.

Alternatively, the magnetic grit 20 comprises a mixture comprising:
- cylindrical bodies;
- bodies of spherical or substantially spherical shape; and
- angular shaped bodies.

As shown in Figures 1 to 3, the nozzles 5 are arranged within the process chamber 2 and are adapted to face the layer 14 of the panel 10 being processed. The nozzles 5 are arranged at the top 2b of the process chamber 2, preferably at a centreline of the process chamber 2 along the direction X.

In detail, the nozzles 5 have a diameter ranging from 5 to 20 mm. In further detail, the nozzles 5 have a diameter ranging from 5 to 12 mm.

In the embodiment shown, the nozzles 5 are nine in number and identical to each other. In addition, the nozzles 5 are aligned with each other along the direction Y.

Preferably, moreover, the nozzles 5 are adapted to eject the magnetic grit 20 against the photovoltaic panel 10 provided with the frame 15 and following the removal of the module 17. In fact, the frame 15 gives rigidity to the photovoltaic panel 10 being processed. Nonetheless, the nozzles 5 are also adapted to eject the magnetic grit 20 against the photovoltaic panel 10 deprived of the frame 15.

As shown in Figure 1, the frame 3 comprises a further opening 3c adapted to allow the discharge of the crushed portions of the photovoltaic panels 10 and the magnetic grit 20 towards the outside of the process chamber 2. In detail, the further opening 3c is arranged at the bottom 2a of the process chamber 2 and is interposed between the openings 3a and 3b along the direction X. In further detail, the opening 3c is at least partially aligned with the nozzles 5 along the directions X and Y.

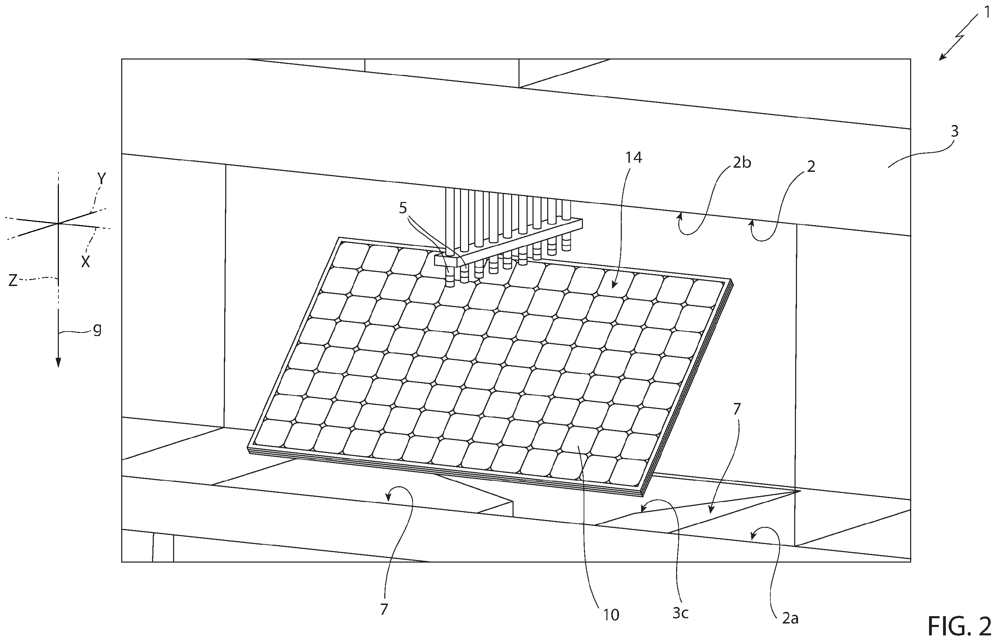

Preferably, the bottom 2a also comprises an inclined portion 7 at the opening 3c, which facilitates the fall of the crushed portions of the photovoltaic panels 10 after impact with the magnetic grit 20 towards the opening 3c (Figures 1 and 2).

In detail, the inclined portion 7 is inclined with respect to the versor of the gravity g acceleration downwards, i.e. towards the ground.

The device 30 for collecting the crushed portions of the photovoltaic panel 10 is arranged below the opening 3c along the direction Z. Preferably, the device 30 comprises a conveyor 32 adapted to transport the crushed portions discharged from the process chamber 2 through the opening 3c, for example towards a collection case 31 (Figure 1). In detail, the conveyor 32 is a conveyor belt.

The device 30 is also adapted to collect the magnetic grit 20 discharged through the opening 3c.

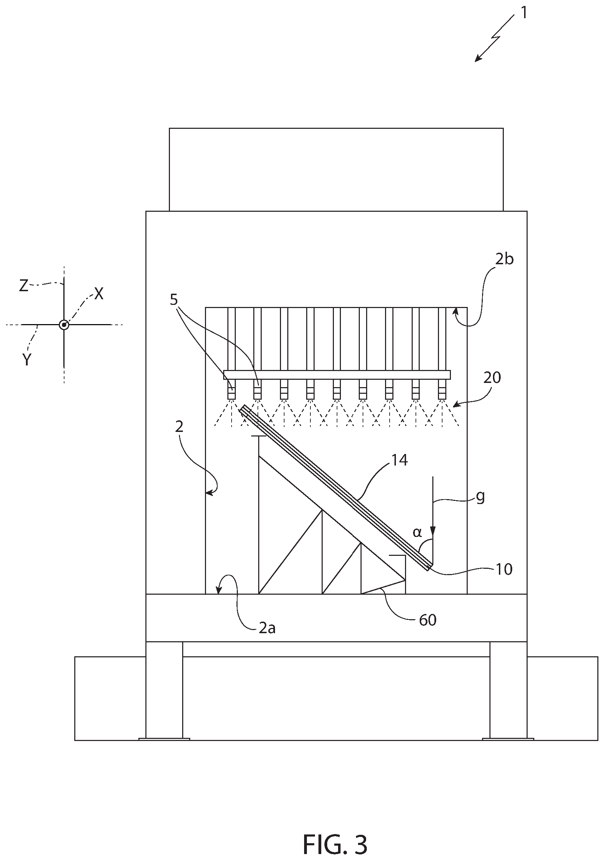

As schematically shown in Figure 3, the system 1 also comprises a structure 60 which is fixed with respect to the frame 3 and adapted to support the photovoltaic panel 10 in an inclined manner with respect to the direction of the versor of the gravity g acceleration.

In detail, the structure 60 is adapted to support the photovoltaic panel 10 in such a way that it forms an angle α with the versor g ranging from 0° to 90°. In further detail, the angle α is ranging from 30° to 60°. For example, the angle α is equal to 45°.

Preferably, the structure 60 is at least partially aligned with the nozzles 5 along the directions X and Y. In particular, the structure 60 is placed directly below the nozzles 5 along the direction Z. In other words, the structure 60 is interposed between the top 2b and the bottom 2a of the process chamber 2 along the direction Z. In this way, during use, the photovoltaic panel 10 is placed directly below the nozzles 5 and directly above the opening 3c along the direction Z.

The system 1 also comprises a device 40 adapted to recover the magnetic grit 20 after impact with the photovoltaic panel 10. Such a device 40 is only schematically shown in Figure 1.

In detail, the device 40 is adapted to attract the magnetic grit 20 present on the conveyor belt 32 by means of a magnetic attraction force.

As schematically shown in Figure 1, the system 1 preferably also comprises a device 70 adapted to carry out the washing and drying of the photovoltaic panels 10, before they are inserted into the process chamber 2. Preferably, the device 70 comprises a pressure washer and/or a glass washer. For example, said device 70 operates at a pressure between 100 and 130 bar.

The operation of the system 1 for the treatment of the photovoltaic panels 10 is described below.

In particular, the photovoltaic panel 10 to be dismounted is subjected to washing and drying by means of the device 70 and subsequently the module 17 of said photovoltaic panel 10 is removed together with the connection cables.

Subsequently, the photovoltaic panel 10 is arranged within the process chamber 2. Specifically, the panel 10 is inserted into the process chamber 2 through the opening 3a and fixed to the structure 60.

At the end of mounting the photovoltaic panel 10 on the structure 60, the photovoltaic panel 10 is inclined with respect to the versor of the gravity g and is turned towards the nozzles 5. In detail, the glass layer 14 of the photovoltaic panel 10 is directly facing the nozzles 5. In more detail, the photovoltaic panel 10 is placed directly below the nozzles 5 and directly above the opening 3c along the direction Z.

Subsequently, the photovoltaic panel 10 is subjected to a step of crushing the layer 14 made of vitreous material. In detail, during this step, at least some of the nozzles 5 emit a flow of compressed air, which carries the magnetic grit 20, which strikes the layer 14, eroding and crushing it.

During this crushing step of the layer 14, the magnetic grit 20 which has struck the layer 14 and the glass fragments of the layer 14 slide towards the bottom 2a of the process chamber 2 by virtue of the inclination of the photovoltaic panel 10. In more detail, the glass fragments and the grit 20 emitted from the nozzles 5 slide along the inclined portion 7, pass through the opening 3c, falling onto the conveyor 32 by gravity.

During the movement of the conveyor 32, the device 40 exerts a magnetic force on the grit mixed with the glass fragments, collecting it. The grit collected by the device 40 is then returned to the nozzles 5.

The glass fragments obtained at the end of the crushing step and collected and transported by the device 30 in the case 31 can then be subjected to recycling processes.

The remaining portions of the photovoltaic panel 10 following the crushing of the layer 14 are then let out of the process chamber 2 through the opening 3b. These remaining portions can then be dismounted and used in related recycling processes.

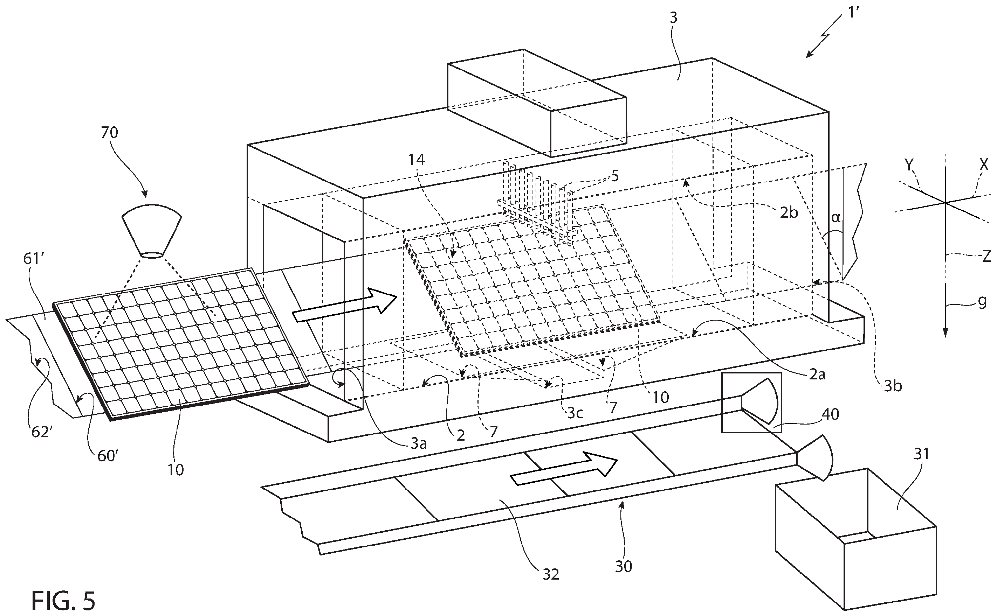

With reference to Figure 5, 1' denotes a system for the treatment of photovoltaic panels 10 according to a second embodiment of the invention. The system 1' is similar to the system 1 and will be described below only insofar as it differs from the latter; equal or equivalent parts of the systems 1; 1' will be marked, where possible, by the same reference numbers.

The system 1' differs from the system 1 in that it comprises a structure 60' instead of the structure 60. The structure 60' comprises a conveyor 61' adapted to move the photovoltaic panels 10 to be dismounted with respect to the process chamber 2.

In detail, the conveyor 61' is adapted to transport within the process chamber 2 the photovoltaic panels 10 to be dismounted through the opening 3a and the remaining portions of the photovoltaic panels 10 at the end of the crushing process outside the process chamber 2 through the opening 3b. In further detail, the conveyor 61' is adapted to transport the photovoltaic panels 10 to be dismounted also at the device 70, to allow them to be washed and dried.

Specifically, the conveyor 61' comprises a conveyor belt.

As shown in Figure 5, the conveyor 61' comprises a support surface 62', which is adapted to receive the photovoltaic panels 10 to be dismounted and which - similarly to the structure 60 - is adapted to support said photovoltaic panels 10 in an inclined manner with respect to the versor of the gravity g acceleration.

In detail, the support surface 62' is adapted to support the photovoltaic panel 10 in such a way that it forms an angle α with the versor g ranging from 0° to 90°. In further detail, the angle α is ranging from 30° to 60°. For example, the angle α is equal to 45°.

Preferably, the structure 60' is at least partially aligned with the nozzles 5 along the directions X and Y within the process chamber 2. In particular, the structure 60' is positioned directly below the nozzles 5 along the direction Z within the process chamber 2. In this way, during the crushing step, the photovoltaic panel 10 is placed directly below the nozzles 5 and directly above the opening 3a along the direction Z.

The operation of the system 1' is similar to the operation of the system 1 and will be described below only insofar as it differs from the latter.

In detail, during use, the photovoltaic panels 10 to be dismounted are transported into the process chamber 2 by the conveyor 61' through the opening 3a and the remaining parts of such photovoltaic panels 10 following the crushing step are transported by the conveyor 61' through the opening 3b.

During transport along the direction X, the photovoltaic panels 10 are inclined with respect to the direction of the versor of the gravity g. This applies in particular also during the crushing step, in which the photovoltaic panel 10 to be dismounted is directly below the nozzles 5 parallel to the direction Z.

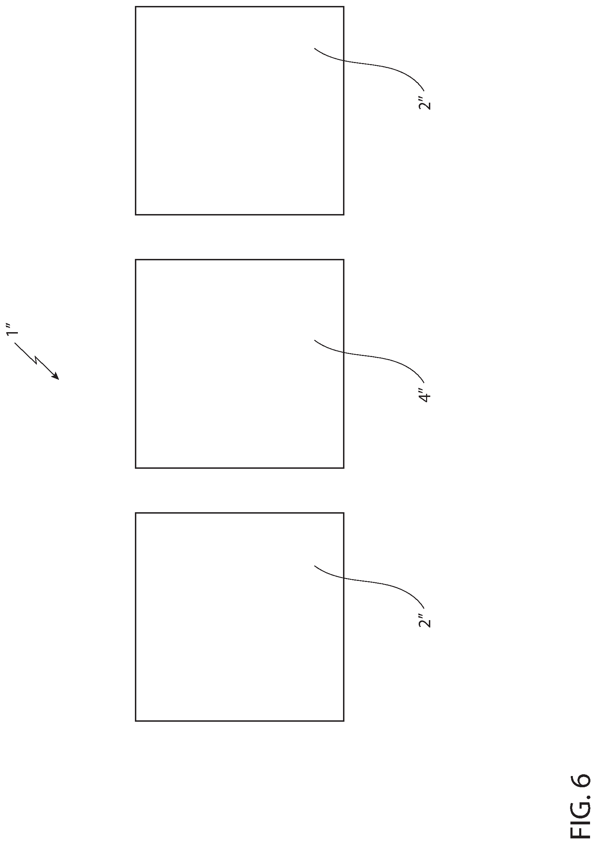

With reference to Figure 6, 1'' denotes a system for the treatment of photovoltaic panels 10'' according to a third embodiment of the invention. The system 1' is similar to the system 1 and will be described below only insofar as it differs from the latter; equal or equivalent parts of the systems 1; 1'' will be marked, where possible, by the same reference numbers.

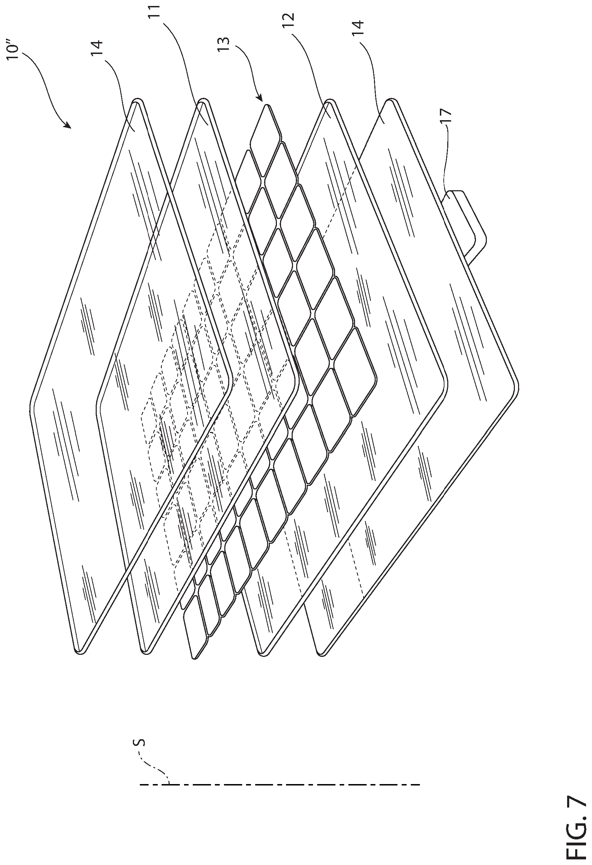

The system 1" is in particular aimed at the treatment of photovoltaic panels 10'' of a different type from the photovoltaic panels 10 shown in Figure 4. Specifically, the photovoltaic panels 10'' are schematically shown in Figure 7 and comprise:
- a first film 11 in a thermoplastic material;
- a second film 12 in a thermoplastic material;
- a layer 13 comprising CGIS photovoltaic cells interposed between the first film 11 and the second film 12 along a direction S of the thickness of the photovoltaic panels 10";
- a first layer 14 made of a vitreous material and arranged on the side of the first film 11 facing away from the layer 13 parallel to the direction S;
- a second layer 14 also made of a vitreous material and arranged on the side of the second film 12 facing away from the layer 13 parallel to the direction S; and
- a module 17 for the electrical connection - for example, to an electrical network - of the photovoltaic panel 10'', in particular a junction box.

In detail, the module 17 is fixed and/or operatively connected to the second layer 14.

In other words, the photovoltaic panels 10" differ from the photovoltaic panels 10 in that they comprise two layers 14 and do not comprise the support layer 16.

Preferably but not necessarily, the photovoltaic panels 10'' dismountable by means of the system 1" have maximum dimensions equal to 2 x 3 m in the plane orthogonal to the direction S of the thickness.

Preferably, the system 1" is adapted to remove both layers 14 of vitreous material from the photovoltaic panels 10", in order to make subsequent recycling possible.

The system 1'' differs from the system 1 in that it comprises (Figure 6):
- a first process chamber 2'', inside which a first step of crushing the photovoltaic panel 10'' takes place;
- an overturning device 4'' of the photovoltaic panel 10'' exiting the first process chamber 2; and
- a second process chamber 2'', inside which a second step of crushing the photovoltaic panel 10'' is carried out as overturned by the overturning device 4''.

The first process chamber 2" is adapted to cause the crushing of the first layer 14, while the second process chamber 2'' is adapted to cause the crushing of the second layer 14.

In detail, the overturning device 4'' is adapted to rotate the photovoltaic panel 10'' coming out of the first process chamber 2", for example by an angle equal to 180° about an axis orthogonal to the thickness direction S of the photovoltaic panel 10'' itself. In this way, the nozzles 5 of the second process chamber 2'' are adapted to be directly turned towards the second layer 14 of the panel 10''.

The overturning device 4'' comprises a robot, for example of the anthropomorphic type.

It is furthermore specified that the first and second process chambers 2" are preferably identical to the process chamber 2.

The operation of the system 1'' is clear in light of the operation of the system 1; therefore, its description is omitted for brevity.

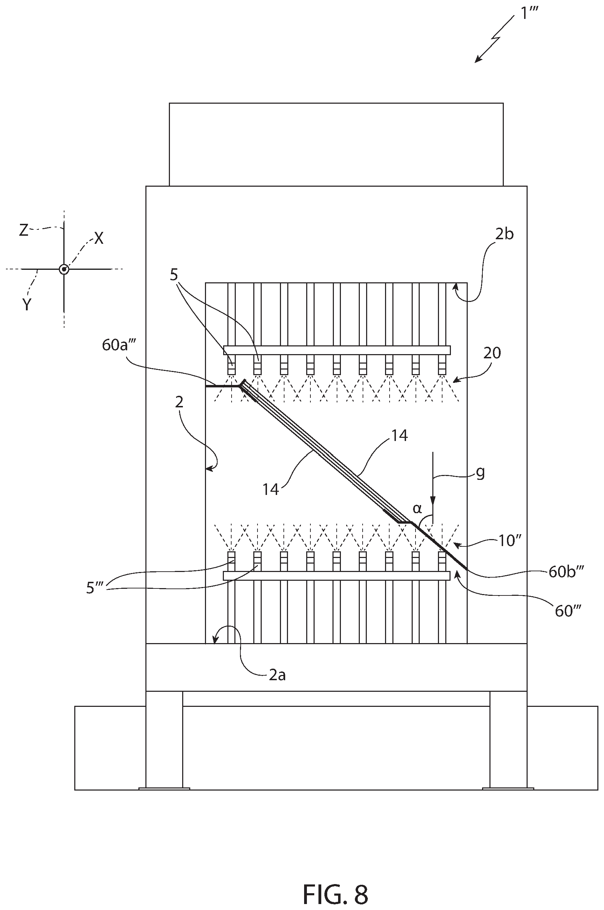

With reference to Figure 8, 1''' denotes a system for the treatment of photovoltaic panels 10 according to a fourth embodiment of the invention. The system 1''' is similar to the system 1 and will be described below only insofar as it differs from the latter; equal or equivalent parts of the systems 1; 1''' will be marked, where possible, by the same reference numbers.

The system 1‴ differs from the system 1 in that it comprises further nozzles 5''' adapted to eject a magnetic grit 20 against the photovoltaic panel 10'' on the opposite side to the nozzles 5.

In detail, the nozzles 5''' are arranged within the process chamber 2 and are adapted to be turned towards the second layer 14 of the panel 10'' being processed while the nozzles 5 are adapted to be turned towards the first layer 14 of the panel 10''. The nozzles 5''', moreover, are arranged at the bottom 2a of the process chamber 2.

Also the nozzles 5''' have a diameter ranging from 5 to 20 mm. In further detail, the nozzles 5''' have a diameter ranging from 5 to 12 mm.

In the embodiment shown, the nozzles 5''' are nine in number and are identical to each other and to the nozzles 5. In addition, the nozzles 5''' are aligned with each other along the direction Y.

The nozzles 5''' are aligned with the nozzles 5 along the direction X or are spaced from the nozzles 5 along the direction X.

As schematically shown in Figure 8, the system 1‴ also comprises a structure 60‴ which is fixed with respect to the frame 3 and adapted to support the photovoltaic panel 10'' in an inclined manner with respect to the versor of the gravity g acceleration.

In detail, the structure 60''' is adapted to support the photovoltaic panel 10'' in such a way that it forms an angle α with the versor g ranging from 0° to 90°. In further detail, the angle α is ranging from 30° to 60°. For example, the angle α is equal to 45°.

Preferably, the structure 60''' is at least partially aligned with the nozzles 5 and/or with the nozzles 5''' along the directions X and Y. In particular, the structure 60''' is interposed between the top 2b and the bottom 2a of the process chamber 2 along the direction Z. In this way, during use, the photovoltaic panel 10'' is placed directly below the nozzles 5 and directly above the nozzles 5''' along the direction Z.

In the embodiment shown, the structure 60‴ comprises two portions 60a''', 60b''' each adapted to support a respective end of the photovoltaic panel 10'' along the direction Y.

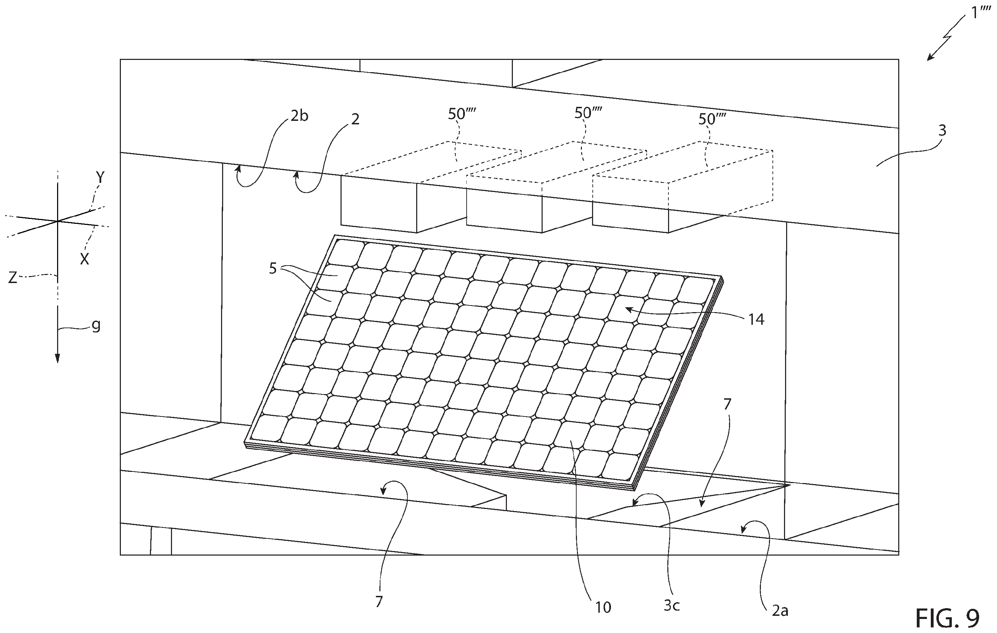

With reference to Figures 9 to 11, 1'''' denotes a system for the treatment of photovoltaic panels 10 according to a fifth embodiment of the invention. The system 1"" is similar to the system 1 and will be described below only insofar as it differs from the latter; equal or equivalent parts of the systems 1; 1'''' will be marked, where possible, by the same reference numbers.

The system 1'''' differs from the system 1 in that it comprises a plurality of centrifugal thrusters 50'''' instead of the nozzles 5.

Similar to the nozzles 5, the centrifugal thrusters 50'''' are adapted to eject the magnetic grit 20 against the photovoltaic panel 10. However, the centrifugal thrusters 50ʺʺ do not convey the magnetic grit 20 thanks to an aeriform flow comprising compressed air.

Otherwise, the centrifugal thrusters 50''' are configured to receive and accelerate a certain amount of magnetic grit 20, projecting it towards the photovoltaic panel 10 to be dismounted. Nevertheless, the operation carried out by the centrifugal thrusters 50'''' on the photovoltaic panel 10 to be dismounted is certainly to be understood as a sandblasting, a shot blasting or a shot peening.

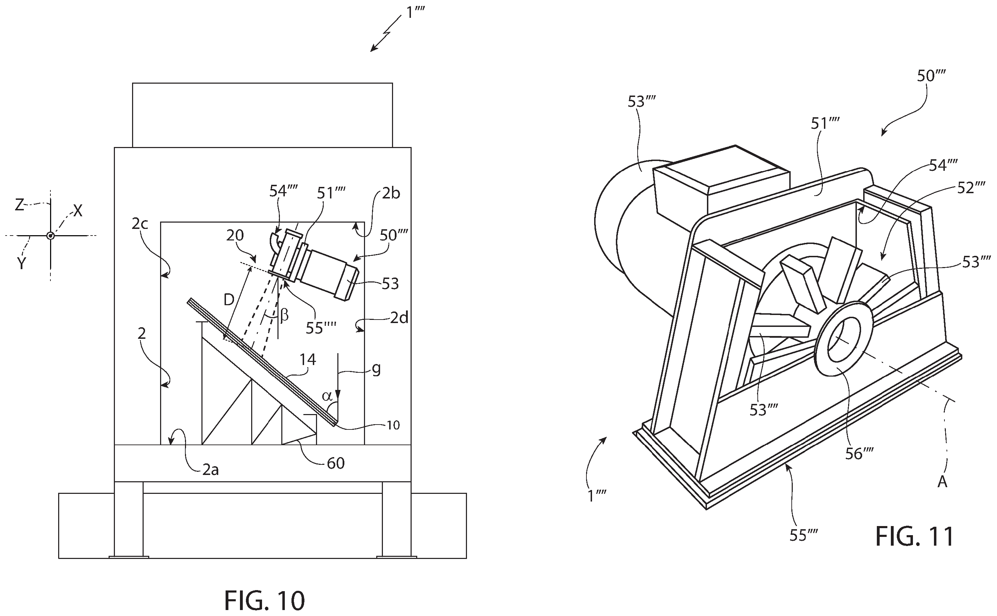

Each centrifugal thruster 50'''' comprises (Figures 10 and 11) :
- a body 51ʺʺ, at which the centrifugal thruster 50'''' is connected to the process chamber 2 and/or to the frame 3;
- an impeller 52'''', which is supported by the body 51'''' rotatably about an axis of rotation A; and
- a source of mechanical energy 53'''', for example an electric motor, which is operatively connected to the impeller 52'''' so as to selectively rotate it around the axis of rotation A.

The impeller 52ʺʺ comprises a plurality of blades 53'''' configured to interact with the magnetic grit 20 and increase the kinetic energy thereof. In detail, the impeller 52'''' comprises a hub 56'''', at which it is operatively connected to the mechanical energy source 53''''. In further detail, the blades 53'''' are fixed with respect to the hub 56'''' and extend from the hub 56'''' radially with respect to the axis of rotation A.

Each centrifugal thruster 50'''' further comprises:
- an opening 54'''' configured to allow the passage of the magnetic grit 20 to be accelerated towards the impeller 52ʺʺ; and
- an opening 55'''' configured to allow the passage of the magnetic grit 20 accelerated by the impeller 52'''' towards the photovoltaic panel 10.

In particular, the openings 54"" and 55'''' are defined and/or obtained in the body 51'''.

As shown in Figure 10, the centrifugal thrusters 50ʺʺ are arranged at least partially within the process chamber 2 and are adapted to be turned towards the layer 14 of the panel 10 being processed. Specifically, the openings 55'''' of the centrifugal thrusters 50'''' are adapted to be turned towards the layer 14 of the panel 10 being processed. In addition, the centrifugal thrusters 50'''' are arranged at the top 2b of the process chamber 2.

The centrifugal thrusters 50'''' are spaced from each other along the direction X and are partially offset from each other along the direction Y. In more detail, at least one of the centrifugal thrusters 50'''' is not aligned with the others along the direction Y. Preferably, moreover, at least one of the centrifugal thrusters 50'''' extends according to the direction Y along a stretch that is common to at least one other of the centrifugal thrusters 50"" (Figure 9).

In detail, the centrifugal thrusters 50'''' are adapted to be arranged at a distance D from the photovoltaic panel 10 to be dismounted and are inclined at an angle β with respect to the direction Z or the versor of the gravity g acceleration. In further detail, the distance D is ranging from 10 mm to 1000 mm and the angle β is ranging from 10° to 170°. Preferably but not necessarily, the angle β is ranging from 30° to 90° (Figure 10).

In the embodiment shown, the centrifugal thrusters 50'''' are three and identical to each other. In further detail, the process chamber 2 comprises two ends 2c, 2d, which are opposed to each other along the direction Y (see Figure 10, in which a single centrifugal thruster 50"" is shown). A first of the three centrifugal thrusters 50"" is closer to the end 2c, a second of the three centrifugal thrusters 50'''' is closer to the end 2d, and the third of the three centrifugal thrusters 50'''' is interposed between the first and second centrifugal thrusters 50'''' along the direction Y.

The operation of the system 1'''' is similar to the operation of the system 1 and will be described below only insofar as it differs from the latter.

In particular, at the end of mounting the photovoltaic panel 10 on the structure 60, the photovoltaic panel 10 is inclined with respect to the versor of gravity g and is turned towards the centrifugal thrusters 50"". In detail, the glass layer 14 of the photovoltaic panel 10 is directly facing the centrifugal thrusters 50''''. In more detail, the photovoltaic panel 10 is placed directly below the centrifugal thrusters 50'''' and directly above the opening 3c along the direction Z.

Subsequently, the photovoltaic panel 10 is subjected to a step of crushing the layer 14 made of vitreous material.

In detail, during this step, the impellers 52ʺʺ of at least some of the centrifugal thrusters 50'''' are set in rotation around the respective axes of rotation A. In more detail, at each of said centrifugal thrusters 50'''', the mechanical grit 20 passing through the opening 54'''' is directed towards the impeller 52'''' and made to impact against the blades 53''''. By virtue of this impact, the grit 20 undergoes centrifugation and is then projected through the opening 55'''' towards the layer 14, eroding and crushing it.

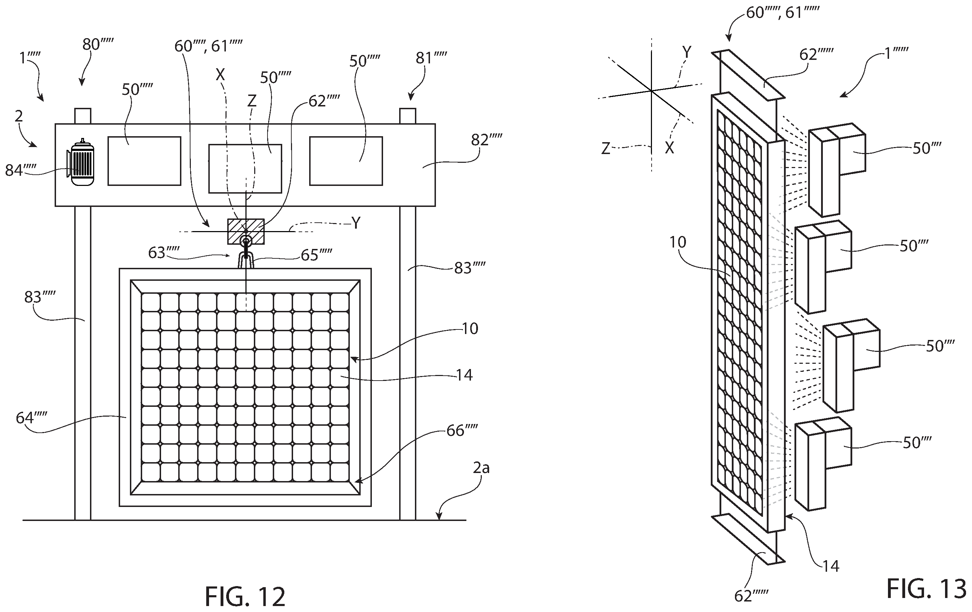

With reference to Figure 12, 1‴ denotes a system for the treatment of photovoltaic panels 10 according to a sixth embodiment of the invention. The system 1''''' is similar to the system 1'''' and will be described below only insofar as it differs from the latter; equal or equivalent parts of the systems 1ʺʺ; 1‴ʺ will be marked, where possible, by the same reference numbers.

The system 1‴ʺ differs from the system 1'''' in that it comprises a movement system 80'''' configured to move the centrifugal thrusters 50''', which are only schematically shown in Figure 12, along the direction Z. In detail, the movement system 80'''' moves the centrifugal thrusters 50'''' with respect to the panel 10 being processed.

In detail, the movement system 80''''', which is arranged at least partially within the process chamber 2, comprises:
- a portal 81""', which is integral with frame 3; and
- a shelf 82""', which is slidable with respect to the portal 81'''' and supports the centrifugal thrusters 50‴.

In further detail, the portal 81''''' comprises a pair of uprights 83"" extending parallel to the direction Z and spaced apart from each other along the direction Y. Each upright 83'''' also comprises a respective track configured to guide the movement of the shelf 82ʺʺ along the direction Z.

The shelf 82''''' extends between the two uprights 83'''' along the direction Y and also supports a mechanical power source 84''''. This mechanical energy source 84''''' is configured to provide the mechanical energy necessary for the movement of the shelf 82''''' with respect to the portal 81'''''. The mechanical energy source 84''''' comprises, for example, an electric motor.

On the shelf 82'''', the centrifugal thrusters 50ʺʺ are at least partially aligned to the direction Y. Also in the configuration shown in Figure 12, moreover, the openings 55'''' of the centrifugal thrusters 50'''' are oriented towards the photovoltaic panel 10 to be dismounted.

The system 1''''' further comprises a structure 60''''' instead of the structure 60. The structure 60''''' comprises a conveyor 61"'" adapted to move the photovoltaic panels 10 to be dismounted with respect to the process chamber 2.

In detail, the conveyor 61'''' is adapted to transport within the process chamber 2 the photovoltaic panels 10 to be dismounted through the opening 3a and the remaining portions of the photovoltaic panels 10 at the end of the crushing process outside the process chamber 2 through the opening 3b.

Specifically, the conveyor 61‴ʺ is an overhead conveyor adapted to support the photovoltaic panels 10 to be dismounted in such a way that they are vertical, in particular orthogonal, to the ground. The conveyor 61"", moreover, is adapted to support the photovoltaic panels 10 so that they are raised with respect to the bottom 2a.

The conveyor 61‴ʺ comprises:
- a fixed rail 62''''', which is directed at least over part of its extension according to the direction X;
- a plurality of carriages 63''''' slidable with respect to the rail 62''''' according to the direction X; and
- a plurality of frames 64''''', each configured to support a respective photovoltaic panel 10 to be dismounted; each frame 64''''' is slidable with respect to the rail 62‴ʺ in an integral manner with respect to a respective carriage 63'''''.

For example, each frame 64''''' is operatively connected to the respective carriage 63''''' by means of a respective hook 65‴ʺ.

The conveyor 61''''', moreover, is interposed between the two uprights 83''''' according to the direction Y. In addition, within the process chamber 2, also the frames 64''''' and the respective photovoltaic panels 10 are interposed between the two uprights 83‴ʺ along the direction Y.

In the embodiment shown, each frame 64'''' comprises a frame of rectangular or quadrangular shape, within which the panel 10 is arranged. In addition, the panel 10 is fixed to the respective frame 64''''' by means of an anchoring system 66'''' comprising, for example, tie rods, springs or hooks.

The operation of the system 1‴ʺ is similar to the operation of the system 1'''' and will be described below only insofar as it differs from the latter.

In particular, the panels 10 to be dismounted, each supported by a respective frame 64‴ʺ, are transported along the process chamber 2 by the conveyor 61''''' until they are aligned and/or facing the portal 81'''''. In detail, the glass layer 14 of the photovoltaic panel 10 is directly facing the centrifugal thrusters 50"".

Subsequently, during the crushing of the layer 14, the shelf 82''''' is made to slide with respect to the portal 81"", so as to project the magnetic grit 20 against different regions of the panel 10 along the direction Z. Preferably, moreover, during crushing, the sliding of the panel 10 with respect to the rail 62''''' along the direction X is interrupted and/or prevented.

At the end of the crushing, the conveyor 61‴ʺ transports the frame 64''''' and any residues, i.e. the remaining portions of the photovoltaic panel 10, out of the process chamber 2.

With reference to Figure 13, 1'''''' denotes a system for the treatment of photovoltaic panels 10 according to a seventh embodiment of the invention. The system 1'''''' is similar to the system 1'''' and will be described below only insofar as it differs from the latter; equal or equivalent parts of the systems 1""; 1""" will be marked, where possible, by the same reference numbers.

The system 1'''''' differs from the system 1'''' in that it comprises a plurality of centrifugal thrusters 50ʺʺ fixed with respect to the frame 3, housed at least partially within the process chamber 2 and arranged at respective different heights along the direction Z. Specifically, the openings 55'''' of the centrifugal thrusters 50'''' are adapted to be turned towards the layer 14 of the panel 10 being processed.

The centrifugal thrusters 50'''' are partially offset from each other along the direction X. In more detail, at least one of the centrifugal thrusters 50'''' is not aligned with the others along the direction X. Preferably, moreover, at least one of the centrifugal thrusters 50'''' extends along the direction X along a section common to at least one other of the centrifugal thrusters 50''''.

The system 1'''''' further comprises a conveyor 61‴ʺ instead of the conveyor 61'''''.

Specifically, the conveyor 61'''''' comprises two rails 62‴‴ fixed and directed at least over part of their extension according to the direction X. The rails 62‴ʺʺ are spaced from each other along the direction Z and each of them is adapted to guide the movement of respective distinct ends according to the direction Z of the panel 10 to be dismounted.

The operation of the system 1""" is analogous to the operation of the system 1''''''; therefore, its detailed description is omitted for brevity.

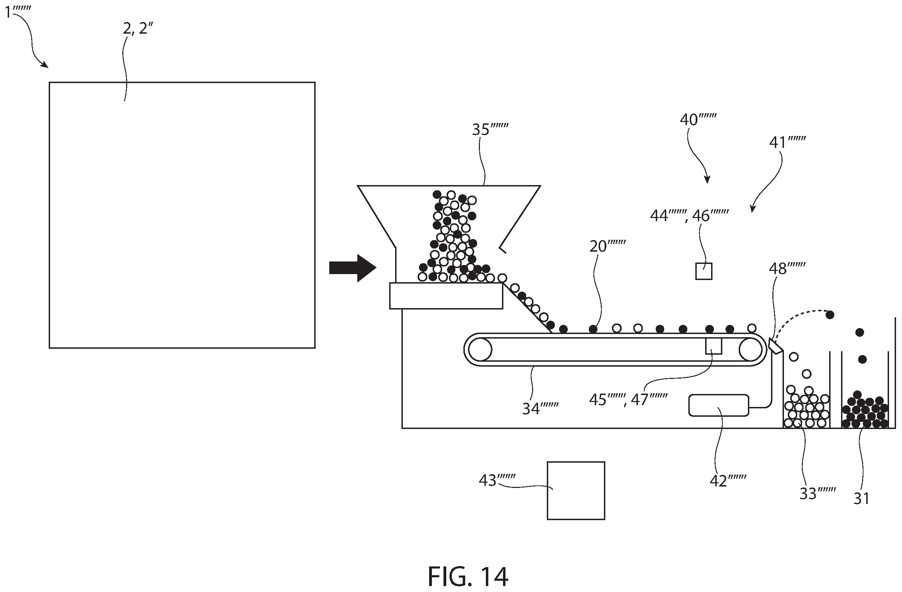

With reference to Figure 14, 1‴ʺʺ denotes a system for the treatment of photovoltaic panels 10; 10'' according to an eighth embodiment of the invention. The system 1''''''' is similar to any one of the systems 1; 1'; 1"; 1‴; 1ʺʺ; 1'''''; 1""" and will be described below only insofar as it differs from the latter; equal or equivalent parts of the systems 1; 1'; 1"; 1"'; 1ʺʺ; 1""'; 1"""; 1''''''' will be marked, where possible, by the same reference numerals.

The system 1'''''''' differs from the systems 1; 1'; 1''; 1'''; 1ʺʺ; 1'''''; 1'''''' in that it is configured to project a non-necessarily magnetic grit 20‴ʺʺ against the photovoltaic panels 10; 10'' to be dismounted and in that it comprises an assembly 40''''''' adapted to recover the grit 20''''''' collected after impact with the photovoltaic panel 10; 10''.

It should be noted that the assembly 40"""' may be arranged downstream of the process chamber 2; 2'' belonging to any of the systems 1; 1'; 1''; 1‴; 1ʺʺ; 1‴‴; 1''''''.

In detail, the grit 20'''''''' is magnetic, diamagnetic, paramagnetic or non-magnetic. In addition, preferably, the shape of the bodies of the grit 20‴ʺʺ is similar to or equal to the shape of the bodies of the magnetic grit 20 described above. For example, the grit 20‴ʺʺ comprises ceramic and/or metallic and/or polymeric bodies.

The assembly 40""'" comprises, in turn:
- a belt conveyor 34‴ʺʺ;
- a hopper 35""" configured to contain the set collected by the device 30 and formed by grit 20"""' and remaining parts of the photovoltaic panels 10; 10'' following the crushing step; the hopper 35"""" is configured to discharge in a controlled manner over time a certain amount of the aforesaid set on the conveyor belt 34""""; and
- a collection case 33‴ʺʺ configured to contain the grit 20'''''''.

In detail, the conveyor belt 34‴ʺʺ extends between the hopper 35‴ʺʺ, the case 31 and the case 33‴ʺʺ.

The assembly 40‴ʺʺ furthermore comprises:
- a sensor system 41‴ʺʺ configured to detect the presence of grit 20‴‴ʺ in said set of grit 20‴‴ʺ and of remaining parts of the photovoltaic panels 10; 10'' directed from the hopper 35‴ʺʺ towards the case 31 and the case 33‴ʺʺ and a quantity associated with the position of the grit 20‴ʺʺ within said set;
- an expulsion system 42"""" configured to selectively remove the grit 20"""" from said set; and
- an electronic control unit 43‴ʺʺ operatively connected to the sensor system 41''''''' and to the expulsion system 42‴ʺʺ.

The electronic control unit 42‴ʺʺ is configured to command the expulsion system 42‴‴ʺ to selectively remove the grit 20''''''' from the set of grit 20‴‴ʺ and of remaining parts of the photovoltaic panels 10; 10'' directed from the hopper 35‴ʺʺ towards the case 31 and the case 33''''''' when the sensor system 41"""' detects its presence and position.

In detail, the expulsion system 42'''''' comprises a plurality of nozzles 48"""' configured to emit a jet of compressed air at the aforesaid set during its fall from the conveyor belt 34"""" to the cases 31, 33‴ʺʺ, so as to separate the grit 20"""' from the crushed glass. In further detail, the nozzles 48'''''' are configured to blow compressed air at the bodies of the grit 20"""' detected by the sensor system 41‴‴ʺ and falling from the conveyor belt 34''''''''', so as to guide the bodies of the grit 20''''''' into the case 33"""'.

According to one embodiment, the sensor system 41‴ʺʺ is of the optical type and comprises:
- a light source 44‴‴, for example an LED light, configured to emit light at the set of grit 20‴ʺʺ and of remaining parts of the photovoltaic panels 10; 10'' directed from the hopper 35"""" towards the case 31 and the case 33''''''''; and
- an image acquisition device 45‴ʺʺ configured to acquire images of the set of grit 20‴ʺʺ and of remaining parts of the photovoltaic panels 10; 10'' directed from the hopper 35"""" towards the case 31 and the case 33‴‴‴ at one or more bands of the electromagnetic spectrum.

In detail, the image acquisition device 45""" comprises a multispectral camera. For example, the image acquisition device is configured to detect images in the visible and infrared spectrum.

It is specified that the position of the image acquisition device 45"""' shown in Figure 14 is to be understood as purely exemplary and not limiting.

The electronic control unit 43""" is configured to receive and process the images detected by the image acquisition device 45""" and to control the expulsion system 42"""' accordingly.

According to a further embodiment, the sensor system 41‴ʺʺ is of the X-ray type and comprises:
- an X-ray emitter 46'''''' configured to emit X-rays at the set of grit 20"""' and of remaining parts of the photovoltaic panels 10; 10'' directed from the hopper 35"""" towards the case 31 and the case 33""""'; and
- an X-ray receiver 47"""' configured to receive the X-rays emitted by the X-ray emitter 46‴ʺʺ and to generate a signal correlated to the received X-rays.

The X-ray receiver 47""" is configured to receive the X-rays after they have passed through the set of grit 20"""' and of remaining parts of the photovoltaic panels 10; 10'' directed from the hopper 35"""" towards the case 31 and the case 33‴ʺʺ .

In further detail, the sensor system 41""" is an X-ray fluorescence system or a *Dual Energy X-ray* system.

The electronic control unit 43‴‴ is configured to receive the signal emitted by the X-ray receiver 47""" and to control the expulsion system 42‴‴ accordingly.

From the foregoing, the advantages of the method for the treatment of photovoltaic panels 10; 10'' and of the system 1; 1'; 1"; 1"'; 1ʺʺ; 1‴ʺ; 1‴‴; 1‴ʺʺ for the treatment of photovoltaic panels 10; 10'' according to the invention are evident.

In particular, since the photovoltaic panel 10; 10'' is hit by the magnetic grit 20 or by the grit 20''''''', it is possible to dismount the photovoltaic panel 10; 10" - and specifically, the layer 14 or the layers 14 - efficiently and economically.

In fact, since the crushing of the layer 14/layers 14 is not carried out by means of grinding blades or rolling rollers, the problems of wear of the components associated with the known recycling processes described in the introductory part of the present description are overcome. Specifically, using the method according to the present invention, wear mainly affects the bodies of the magnetic grit 20 or of the grit 20''''''' and the blades 53"", which can be replaced periodically in a simple and economical way.

Moreover, the crushing of the layer 14/layers 14 obtained thanks to the impact with the magnetic grit 20 or with the grit 20''''''' is achieved in a short time and allows to achieve high processing speeds.

In addition, the crushed glass obtained is easily recyclable, as it is scarcely or not at all polluted by other components of the photovoltaic panel 10; 10''. The remaining parts of the photovoltaic panel 10; 10" following the removal of the layer 14/layers 14 are also more easily recyclable, as they are deprived of the glass parts.

Since the grit 20 is made of a magnetic material and the system 1 comprises the device 40, it is possible to easily remove the magnetic grit 20 from the process chamber 2; 2'' once the crushing of the layer 14/layers 14 has been carried out and put it back into circulation, i.e. eject it again from the nozzles 5; 5‴/from the centrifugal thrusters 50'''' in the process chamber 2; 2'' during a subsequent step of emission of the magnetic grit 20.

Since the grit 20‴ʺʺ is made of a material that is not necessarily magnetic and the system 1‴ʺʺ comprises the assembly 40"""', it is possible to easily remove the grit 20‴ʺʺ from the process chamber 2; 2'' once the crushing of the layer 14/of the layers 14 has been carried out and put it back into circulation, i.e. eject it again from the nozzles 5; 5‴/from the centrifugal thrusters 50''''' in the process chamber 2; 2'' during a subsequent step of emission of the grit 20‴ʺʺ.

The Applicant has also observed that the diameters indicated for the bodies of the magnetic grit 20/ of the grit 20‴ʺʺ are particularly effective in achieving the crushing of the layer 14.

Since the panel 10; 10'' is inclined with respect to the versor of the gravity g acceleration, it is possible to facilitate the descent by gravity of the crushed glass fragments of the layer 14/layers 14 towards the device 30.

Since the system 1""; 1""'; 1"""; 1''''''' comprises the centrifugal thrusters 50ʺʺ instead of the nozzles 5; 5‴, it is possible to avoid some plant complications related to the use of compressed air. Moreover, the particles accelerated by the blades 53'''' reach a very high kinetic energy, which allows the treatment of the photovoltaic panel 10; 10'' to be carried out in a very short time.

Finally, it is clear that the method for the treatment of the photovoltaic panels 10; 10'' and the system 1; 1'; 1"; 1"'; 1""; 1""'; 1"""; 1''''''' for the treatment of the photovoltaic panels according to the invention may be subject to modifications and variants which, however, do not fall outside the scope of protection defined by the claims.

The process chamber 2; 2'' could be adapted to accommodate a plurality of photovoltaic panels 10; 10'' at the same time.

System 1; 1'; 1"; 1'''; 1''''''' could comprise a different number of nozzles 5; 5'''. In particular, the system 1; 1'; 1"; 1'''; 1‴ʺʺ could comprise a single nozzle 5; 5''', less than nine nozzles 5; 5''' or more than nine nozzles 5; 5'''.

The system 1''''; 1""'; 1"""; 1‴ʺʺ could comprise a different number of centrifugal thrusters 50''''. In particular, the system 1""; 1""'; 1‴ʺʺ could comprise a single centrifugal thruster 50''''; the system 1''''; 1'''''; 1''''''; 1''''''' could comprise two centrifugal thrusters 50'''' or more than two centrifugal thrusters 50ʺʺ.

The system 1'' could comprise a conveyor similar to the conveyor 61' adapted to transport the photovoltaic panels 10'' to be dismounted from the first process chamber 2'' to the second process chamber 2''.

The system 1'''' could comprise a structure 60' instead of the structure 60.

The system 1'' could further comprise a device 70 for high-pressure washing and drying of the photovoltaic panels 10" interposed between the first process chamber 2'' and the second process chamber 2''. This device 70 would be adapted to wash and dry the photovoltaic panels 10'' exiting the first process chamber 2'', before they reach the second process chamber 2''.

The overturning device 4'' could be integrated in the first process chamber 2''. In this way, the crushed glass possibly remaining on the photovoltaic panel 10' being processed can be dropped towards the bottom of the first process chamber 2'' and let out through the opening 3c of the first process chamber 2'', before the photovoltaic panel 10" to be dismounted reaches the second process chamber 2".

In the system 1", moreover, the first process chamber 2'' and/or the second process chamber 2" could comprise centrifugal thrusters 50'''' instead of the nozzles 5. In particular, the centrifugal thrusters 50'''' could be arranged similarly to what happens for the system 1"", the system 1''''' and/or the system 1''''''.

The structure 60''' could comprise a conveyor belt similarly to the structure 60'. This conveyor belt would be able to move the photovoltaic panels 10'' with respect to the process chamber 2 along the direction X.

The centrifugal thrusters 50'''' could be at least partially arranged outside the process chamber 2, while continuing to be turned towards the layer 14 of the panel 10 being processed.

In the systems 1"" and 1""", the centrifugal thrusters 50'''' could be aligned with each other according to the directions X and/or Y.

The systems 1"", 1''''', 1‴‴ could be adapted to process photovoltaic panels 10''.

Specifically, the system 1""; 1""" could comprise at least one first centrifugal thruster 50‴ʺ adapted to be turned towards the first layer 14 of the panel 10 being processed and at least one second centrifugal thruster 50''''' adapted to be turned towards the second layer 14 of the panel 10''.

The system 1‴ʺ could comprise two movement systems 80‴ʺ, one of which comprises a shelf 82‴ʺ supporting at least one first centrifugal thruster 50‴ʺ adapted to face the first layer 14 of the panel 10'' and the other of which comprises a further shelf 82''''' supporting at least one second centrifugal thruster 50 '''''' adapted to face the second layer 14 of the panel 10''.

## Claims

1. Method for the treatment of photovoltaic panels (10'') comprising the steps of:
i) arranging at least one said photovoltaic panel (10'') in a process chamber (2"); said photovoltaic panel (10") comprising at least one layer (14) made of a vitreous material;
ii) hitting said photovoltaic panel (10") with a grit (20; 20"""'), so as to achieve the crushing of said layer (14);
iii) collecting the vitreous material obtained following said step ii);
**characterized by** comprising the further steps of:
iv) overturning said photovoltaic panel (10") obtained at the end of said step ii); said photovoltaic panel (10") comprising a further layer (14) made of a vitreous material;
v) arranging said overturned photovoltaic panel (10") in a further process chamber (2'');
vi) hitting said photovoltaic panel (10'') with said grit (20; 20"""') on the side of said further layer (14), so as to achieve the crushing of said further layer (14).

2. Method according to claim 1, wherein during said step ii) said grit (20; 20"""') is emitted from at least one nozzle (5) and said layer (14) is at least partially directed towards said at least one nozzle (5).

3. Method according to claim 1, wherein during said step ii) said grit (20; 20"""') is emitted by at least one centrifugal thruster (50'''') and said layer (14) is at least partially turned towards said at least one centrifugal thruster (50'''');
wherein each said centrifugal thruster (50'''') comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52"") and is configured to drive said impeller (52'''') in rotation about said axis of rotation (A);
- a first opening (54'''') configured to allow the passage of said grit (20; 20"""') to be accelerated towards said impeller (52""); and
- a second opening (55"") configured to allow the passage of said grit (20; 20"""') accelerated, in use, by said impeller (52"") towards said photovoltaic panel (10'').

4. Method for the treatment of photovoltaic panels (10") comprising the steps of:
i) arranging at least one said photovoltaic panel (10'') in a process chamber (2); said photovoltaic panel (10") comprising at least one layer (14) made of a vitreous material;
ii) hitting said photovoltaic panel (10") with a grit (20; 20'''''''), so as to achieve the crushing of said layer (14);
iii) collecting the vitreous material obtained following said step ii);
wherein during said step ii) said grit (20; 20‴ʺʺ) is emitted from at least one nozzle (5) and said layer (14) is at least partially directed towards said at least one nozzle (5);
said method comprising the further step vii) of hitting said photovoltaic panel (10") with said grit (20; 20"""'), so as to achieve the crushing of a further layer (14) of said photovoltaic panel (10");
wherein during said step vii) said grit (20; 20‴ʺʺ) is emitted by at least one further nozzle (5‴), said further layer (14) is at least partially turned towards said further nozzle (5'''') and said further nozzle (5"') is arranged opposed to said nozzle (5) with respect to said photovoltaic panel (10'') being treated;
said step vii) being simultaneous with or subsequent to said step ii).

5. Method for the treatment of photovoltaic panels (10") comprising the steps of:
i) arranging at least one said photovoltaic panel (10'') in a process chamber (2"); said photovoltaic panel (10") comprising at least one layer (14) made of a vitreous material;
ii) hitting said photovoltaic panel (10") with a grit (20; 20"""'), so as to achieve the crushing of said layer (14);
iii) collecting the vitreous material obtained following said step ii);
wherein during said step ii) said grit (20; 20‴ʺʺ) is emitted by at least one centrifugal thruster (50'''') and said layer (14) is at least partially turned towards said at least one centrifugal thruster (50"");
said method comprising the further step viii) of hitting said photovoltaic panel (10") with said grit (20; 20"""'), so as to achieve the crushing of a further layer (14) of said photovoltaic panel (10");
wherein during said step viii) said grit (20; 20‴ʺʺ) is emitted by at least one further centrifugal thruster (50ʺʺ), said further layer (14) is at least partially turned towards said further centrifugal thruster (50'''') and said further centrifugal thruster (50'''') is opposite said centrifugal thruster (50"") with respect to said photovoltaic panel (10'') being treated;
wherein each said centrifugal thruster (50'''') and each said further centrifugal thruster (50ʺʺ) comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52ʺʺ) and is configured to drive said impeller (52'''') in rotation about said axis of rotation (A);
- a first opening (54'''') configured to allow the passage of said grit (20; 20"""') to be accelerated towards said impeller (52""); and
- a second opening (55"") configured to allow the passage of said grit (20; 20"""') accelerated, in use, by said impeller (52ʺʺ) towards said photovoltaic panel (10'');
said step viii) being simultaneous with or subsequent to said step ii).

6. Method according to any one of the foregoing claims, wherein during said step i), said photovoltaic panel (10") is inclined with respect to the direction of the versor of the gravity acceleration (g) or is parallel to the direction of the versor of the gravity acceleration (g).

7. Method according to any one of the preceding claims, wherein said grit (20) is magnetic and said method comprises the further step ix) of collecting said magnetic grit (20) following said step ii) by means of a magnetic attraction force; or
wherein said grit (20"""') is magnetic, paramagnetic, diamagnetic or non-magnetic;
said method comprising the steps of:
x) obtaining a set of said grit (20"""') and of said vitreous material following said step ii);
xi) detecting the presence and/or position of said grit (20''''''') within said set; and
xii) selectively removing said grit (20''''''') from said set.

8. System (1") for the treatment of photovoltaic panels (10'') comprising:
- a first process chamber (2") and a second process chamber (2''), which are adapted to accommodate, in use, a photovoltaic panel (10'');
- at least one first nozzle (5) and at least one second nozzle (5) respectively arranged inside said first process chamber (2") and said second process chamber (2"); said first nozzle (5) and said second nozzle (5) being adapted to eject, in use, a grit (20; 20''''''') against said photovoltaic panel (10'') in order to cause at least partial crushing thereof; and
- a device (30) for collecting the crushed portions of said photovoltaic panel (10'');
wherein said first process chamber (2'') is adapted to house a first step of emission of said grit (20; 20‴ʺʺ) against said photovoltaic panel (10'');
said system (1") further comprising an overturning device (4'') of said photovoltaic panel (10'');
wherein said second process chamber (2'') is adapted to house a second step of emission of said grit (20; 20‴ʺʺ) against said photovoltaic panel (10'') overturned, in use, by said overturning device (4'').

9. System (1") for the treatment of photovoltaic panels (10'') comprising:
- a first process chamber (2") and a second process chamber (2''), which are adapted to accommodate, in use, a photovoltaic panel (10'');
- at least one first centrifugal thruster (50"") and at least one second centrifugal thruster (50ʺʺ) respectively arranged inside said first process chamber (2") and said second process chamber (2''); said first centrifugal thruster (50'''') and said second centrifugal thruster (50'''') being adapted to eject, in use, a grit (20; 20"""') against said photovoltaic panel (10'') in order to cause at least partial crushing thereof; and
- a device (30) for collecting the crushed portions of said photovoltaic panel (10");
wherein said first process chamber (2") is adapted to house a first step of emission of said grit (20; 20‴ʺʺ) against said photovoltaic panel (10'');
said system (1'') further comprising an overturning device (4") of said photovoltaic panel (10'');
wherein said second process chamber (2") is adapted to house a second step of emission of said grit (20; 20‴ʺʺ) against said photovoltaic panel (10") overturned, in use, by said overturning device (4").
wherein each said first centrifugal thruster (50'''') and each said second centrifugal thruster (50'''') comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52"") and is configured to drive said impeller (52"") in rotation about said axis of rotation (A);
- a first opening (54'''') configured to allow the passage of said grit (20; 20"""') to be accelerated towards said impeller (52''''); and
- a second opening (55"") configured to allow the passage of said grit (20; 20"""') accelerated, in use, by said impeller (52'''') towards said photovoltaic panel (10'').

10. System (1") for the treatment of photovoltaic panels (10'') comprising:
- a process chamber (2; 2'') adapted to accommodate, in use, a photovoltaic panel (10'');
- at least one nozzle (5; 5''') and at least one centrifugal thruster (50"") arranged inside said process chamber (2; 2") and adapted to eject, in use, a grit (20; 20‴ʺʺ) against said photovoltaic panel (10") in order to cause at least partial crushing thereof; and
- a device (30) for collecting the crushed portions of said photovoltaic panel (10'');
**characterized in that** it comprises:
- a first said process chamber (2'') adapted to house a first step of emission of said grit (20; 20"""') against said photovoltaic panel (10'');
- an overturning device (4'') of said photovoltaic panel (10"); and
- a second said process chamber (2"), adapted to house a second step of emission of said grit (20; 20''''''') against said photovoltaic panel (10'') overturned, in use, by said overturning device (4'');
wherein each said centrifugal thruster (50'''') comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52"") and is configured to drive said impeller (52"") in rotation about said axis of rotation (A);
- a first opening (54'''') configured to allow the passage of said grit (20; 20‴ʺʺ) to be accelerated towards said impeller (52""); and
- a second opening (55"") configured to allow the passage of said grit (20; 20''''''') accelerated, in use, by said impeller (52"") towards said photovoltaic panel (10").

11. System (1''') for the treatment of photovoltaic panels (10'') comprising:
- a process chamber (2) adapted to accommodate, in use, a photovoltaic panel (10'');
- at least one nozzle (5; 5''') arranged inside said process chamber (2) and adapted to eject, in use, a grit (20; 20''''''') against said photovoltaic panel (10'') in order to cause at least partial crushing thereof; and
- a device (30) for collecting the crushed portions of said photovoltaic panel (10'');
wherein said process chamber (2) comprises a bottom (2a) and a top (2b), which are opposed to each other along a direction (Z), which is vertical, in use;
said system (1''') further comprising:
- at least a first said nozzle (5) arranged at said top (2b); and
- at least one second said nozzle (5''') arranged at said bottom (2a);
said at least first nozzle (5) and said at least second nozzle (5''') being adapted to eject, in use, said grit (20; 20"""') against respective opposite parts of said photovoltaic panel (10'').

12. System (1''') for the treatment of photovoltaic panels (10'') comprising:
- a process chamber (2) adapted to accommodate, in use, a photovoltaic panel (10'');
- at least one centrifugal thruster (50'''') arranged inside said process chamber (2) and adapted to eject, in use, a grit (20; 20"""') against said photovoltaic panel (10") in order to cause at least partial crushing thereof; and
- a device (30) for collecting the crushed portions of said photovoltaic panel (10");
wherein said process chamber (2) comprises a bottom (2a) and a top (2b), which are opposed to each other along a direction (Z), which is vertical, in use;
said system (1''') further comprising:
- a said centrifugal thruster (50"") arranged at said top (2b); and
- a further said centrifugal thruster (50'''') arranged at said bottom (2a);
said at least one centrifugal thruster (50"") and said at least one further centrifugal thruster (50"") being adapted to eject, in use, said grit (20; 20"""') against respective parts of said photovoltaic panel (10'') that are opposed to each other;
wherein each said centrifugal thruster (50ʺʺ) and said further centrifugal thruster (50"") comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52"") and is configured to drive said impeller (52"") in rotation about said axis of rotation (A);
- a first opening (54'''') configured to allow the passage of said grit (20; 20"""') to be accelerated towards said impeller (52''''); and
- a second opening (55"") configured to allow the passage of said grit (20; 20"""') accelerated, in use, by said impeller (52"") towards said photovoltaic panel (10'').

13. System (1''') for the treatment of photovoltaic panels (10'') comprising:
- a process chamber (2) adapted to accommodate, in use, a photovoltaic panel (10");
- at least one nozzle (5; 5''') and at least one centrifugal thruster (50'''') arranged inside said process chamber (2) and adapted to eject, in use, a grit (20; 20‴ʺʺ) against said photovoltaic panel (10") in order to cause at least partial crushing thereof; and
- a device (30) for collecting the crushed portions of said photovoltaic panel (10'');
wherein said process chamber (2) comprises a bottom (2a) and a top (2b), which are opposed to each other along a direction (Z), which is vertical, in use;
said system (1''') further comprising:
- at least one first said nozzle (5) and at least one said centrifugal thruster (50'''') arranged at said top (2b); and
- at least one second said nozzle (5''') and at least one further said centrifugal thruster (50'''') arranged at said bottom (2a);
said at least one first nozzle (5) and said at least one second nozzle (5''') being adapted to eject, in use, said grit (20; 20"""') against respective opposite parts of said photovoltaic panel (10'');
said at least one centrifugal thruster (50"") and said at least one further centrifugal thruster (50"") being adapted to eject, in use, said grit (20; 20"""') against respective parts of said photovoltaic panel (10'') that are opposed to each other;
wherein each said centrifugal thruster (50ʺʺ) and said further centrifugal thruster (50'''') comprises:
- a body (51'''');
- an impeller (52""), which comprises a plurality of blades and is supported by said body (51'''') in a rotatable manner about an axis of rotation (A); and
- a source of mechanical energy (53''''), which is operatively connected to said impeller (52"") and is configured to drive said impeller (52'''') in rotation about said axis of rotation (A);
- a first opening (54'''') configured to allow the passage of said grit (20; 20"""') to be accelerated towards said impeller (52""); and
- a second opening (55'''') configured to allow the passage of said grit (20; 20"""') accelerated, in use, by said impeller (52'''') towards said photovoltaic panel (10").

14. System according to any one of claims 8 to 13, comprising a structure (60; 60'; 60‴) adapted to support, in use, said photovoltaic panel (10'') in an inclined manner with respect to the direction of the versor of the gravity (g) acceleration; or
comprising a structure (60''''; 60'''''') adapted to support, in use, said photovoltaic panel (10'') in a manner parallel to the direction of the versor of the gravity (g) acceleration.

15. System according to any one of claims 8 to 14, wherein said grit (20) is magnetic and said system (1"; 1"') comprises a device (40) adapted to collect said magnetic grit (20) by means of a magnetic attraction force; or
wherein said grit (20"""') is magnetic, paramagnetic, diamagnetic or non-magnetic and said system (1"""') comprises an assembly (40"""') adapted to separate said grit (20"""") from a set of said grit (20"""") and of said vitreous material obtained, in use, following said crushing;
said assembly (40"""') comprising:
- a sensor system (41‴ʺʺ) configured to detect the presence and/or position of said grit (20"""") within said set;
- an expulsion system (42"""') configured to selectively remove said grit (20"""') from said set; and
- an electronic control unit (43‴ʺʺ) operatively connected to said sensor system (41"""') and to said expulsion system (42‴ʺʺ);
said electronic control unit (42"""') being configured to command said expulsion system (42"""') to selectively remove said grit (20"""') from said set when said sensor system (41"""') detects the presence and/or position of said grit (20‴‴ʺ) within said set.
